(19) Europäisches Patentamt / European Patent Office / Office européen des brevets

(11) **EP 4 628 917 A1**

(12) **EUROPEAN PATENT APPLICATION**
published in accordance with Art. 153(4) EPC

(43) Date of publication:
08.10.2025 Bulletin 2025/41

(21) Application number: 23927110.9

(22) Date of filing: 31.10.2023

(51) International Patent Classification (IPC):
**G01R 31/40** (2020.01)  **H02M 1/08** (2006.01)

(52) Cooperative Patent Classification (CPC):
**G01R 31/40; H02M 1/08**

(86) International application number:
**PCT/CN2023/128048**

(87) International publication number:
**WO 2024/187769 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 16.03.2023 CN 202310251065

(71) Applicant: SHENZHEN POWEROAK NEWENER CO., LTD
Shenzhen, Guangdong 518000 (CN)

(72) Inventors:
• LEI, Jianhua
  Shenzhen, Guangdong 518000 (CN)
• MA, Hui
  Shenzhen, Guangdong 518000 (CN)
• HUANG, Zhiheng
  Shenzhen, Guangdong 518000 (CN)
• GUO, Zhihua
  Shenzhen, Guangdong 518000 (CN)
• MA, Changfeng
  Shenzhen, Guangdong 518000 (CN)

(74) Representative: Ipside
7-9 Allée Haussmann
33300 Bordeaux Cedex (FR)

(54) **LOAD CONNECTION STATE DETECTION FOR ENERGY STORAGE POWER SUPPLY, ENERGY SAVING CONTROL METHOD FOR ENERGY STORAGE POWER SUPPLY, AND ENERGY STORAGE POWER SUPPLY**

(57)     A load connection state detection method for an energy storage power supply. The energy storage power supply comprises an inverter power supply. The method comprises the following steps: sampling an output voltage and an output current of the inverter power supply, and calculating output apparent power (S1); and determining whether the apparent power is less than a preset power threshold; if the apparent power is greater than the preset power threshold, a detection result being that a load is connected to the energy storage power supply; and if the apparent power is less than the preset power threshold, executing an active load online detection algorithm for secondary detection, and according to the secondary detection result, determining whether a load is connected (S2). According to the method, the load connection state can be automatically identified, the misjudgment of the load connection state is reduced when the connected load is a low-power load, and the detection accuracy of the load connection state of the energy storage power supply is improved, thereby avoiding a load power failure caused by misjudgment and shutdown of the output of the inverter power supply.

Sampling an output voltage and an output current of the inverter power supply, and calculating output apparent power — S1

Determining whether the apparent power is less than a preset power threshold; if the apparent power is greater than the preset power threshold, determining that a load is connected to the energy storage power supply; and if the apparent power is less than the preset power threshold, executing an active load online detection algorithm to perform a secondary detection, and according to the secondary detection result, determining whether a load is connected — S2

FIG.1

EP 4 628 917 A1

## Description

### Technical Field

The present invention relate to the field of energy storage power supply, and in particular, relates to load connection state detection for energy storage power supply, energy saving control method for energy storage power supply, and energy storage power supply.

### Background of the Invention

The technical progress and process improvement of lithium batteries have stimulated the demand for convenient off-grid power consumption in outdoor or home scenes, and thus the scale of the portable energy storage market has experienced explosive growth. However, due to the requirements of the portable energy storage power supply for volume and weight, the built-in battery capacity of the portable energy storage power supply is strictly limited. In order to improve the standby time of the energy storage power supply, reduce the battery power consumption, and solve the problem of excessively rapid discharge of the battery due to no-load operation of the power supply when the user forgets to shut down the output of the energy storage power supply or the load stops working, how to reduce the no-load loss of the energy storage power supply becomes an urgent problem to be solved.

There are two existing technical schemes to reduce the off-grid no-load loss of the inverter power supply. The first scheme is to detect the output power of the inverter power supply, and when the output power is less than a preset threshold value for a period of time, determine that the inverter power supply is in a no-load state and shut down the output, thereby reducing the no-load loss. The second scheme is to design a specialized load detection circuit, so that the power output can be automatically initiated when it is detected that a load is connected, and the power output can be automatically shut down when it is detected that the load is turned off, thereby reducing the battery power consumption.

The first scheme described above is realized by software logic, which does not need to increase additional hardware cost and volume occupation, but is limited by the power sampling accuracy. When a low-power load is connected, the inverter power supply may mistakenly determine that no load is connected and thus shut down the output of the power supply, which leads to power failure of the load. In addition to this disadvantage, when the load is connected again, the inverter power supply cannot automatically identify the connection of the load to reboot but must be operated manually, which reduces the convenience of use of the power supply.

The second scheme described above is realized by a hardware function circuit, which can automatically identify the load connection state and realize automatic power-on/off control of the power supply under loaded conditions, but the specialized load detection circuit increases the hardware cost, increases the volume and weight of the power supply, and reduces the portability. Meanwhile, the complex circuit introduces more instability and a greater failure rate to the power supply system.

### Summary of the Invention

The present invention aims to solve the problems of improving the accuracy of load connection state detection for energy storage power supply and reducing the no-load loss of the energy storage power supply on the premise of realizing automatic startup of the energy storage power supply under loaded conditions, and provides load connection state detection for energy storage power supply, energy saving control method for energy storage power supply, and energy storage power supply.

The technical problem of the present invention is solved by the following technical solutions.

A load connection state detection method for an energy storage power supply is provided, the energy storage power supply includes an inverter power supply, and the method includes the following steps:

S1: sampling an output voltage and an output current of the inverter power supply, and calculating output apparent power;

S2: determining whether the apparent power is less than a preset power threshold; if the apparent power is greater than the preset power threshold, determining that a load is connected to the energy storage power supply; and if the apparent power is less than the preset power threshold, executing an active load online detection algorithm to perform a secondary detection, and according to the secondary detection result, determining whether a load is connected.

In some embodiments, the active load online detection algorithm includes: actively injecting a voltage excitation to an output port of the inverter power supply, detecting the voltage response at the output port, and determining whether a load is connected according to the voltage response.

In some embodiments, the inverter power supply includes an inverter bridge, a controller and an AC output filter circuit, the inverter bridge is connected with the AC output filter circuit, the controller is connected with the inverter bridge and the AC output filter circuit, the AC output filter circuit includes a filter capacitor and a discharge resistor connected in parallel with the filter capacitor, the AC output filter circuit is connected in parallel with a load when the load is connected; and the step of actively injecting a voltage excitation into an output port of the inverter power supply, detecting a voltage response at the output port after the voltage excitation, and determining whether a load is connected according to the voltage response further includes the following steps:

A1: controlling, by the controller, a driving of the inverter bridge to initiate waveform generation starting from the zero point of the sinusoidal reference wave, and performing waveform blocking by disabling a driving signal at the peak of the sinusoidal reference wave, so that the voltage across the filter capacitor becomes the rated peak voltage of the inverter power supply;

A2: starting a timing process upon performing waveform blocking by disabling the driving signal, and sampling and monitoring the voltage across the filter capacitor in real time during the timing process;

A3: stopping the timing process when the voltage across the filter capacitor is detected to have dropped to a preset voltage value, and obtaining a timing value, the timing value being the discharge duration of the voltage across the filter capacitor from the rated peak voltage to the preset voltage value;

A4: calculating a rated power of the connected load according to the timing value, and determining whether the rated power of the load is less than a preset load power threshold; if the rated power of the load is greater than the preset load power threshold, determining that a load is connected to the energy storage power supply; and if the rated power of the load is less than the preset load power threshold, determining that no load is connected to the energy storage power supply.

In some embodiments, the preset voltage value is 3% to 10% of the rated peak voltage of the inverter power supply.

In some embodiments, the preset voltage value is 5% of the rated peak voltage of the inverter power supply.

The present invention further provides an energy saving control method for an energy storage power supply, which includes the following steps :

B1: executing the load connection state detection method for the energy storage power supply described above to detect the load connection state of the energy storage power supply;

B2: if the detection result is that a load is connected to the energy storage power supply, the controller controls a driving of the inverter bridge to initiate waveform generation thereby causing an inverter power supply to resume output of a rated AC sinusoidal waveform;

B3: if the detection result is that no load is connected to the energy storage power supply, and after the filter capacitor is discharged to a preset voltage value, the controller controls the driving of the inverter bridge to initiate waveform generation so as to execute the active load online detection algorithm.

The present invention further provides a computer-readable storage medium storing a computer program, and the computer program, when executed by a processor, implements the steps of the load connection state detection method for the energy storage power supply described above.

The present invention further provides a computer-readable storage medium storing a computer program, and the computer program, when executed by a processor, implements the steps of the energy saving control method for the energy storage power supply described above.

The present invention further provides an energy storage power supply which includes a computer-readable storage medium and a processor, the computer-readable storage medium stores a computer program, and the computer program, when executed by the processor, implements the steps of the energy saving control method for the energy storage power supply described above.

As compared to the prior art, the present invention has the following beneficial effects:
according to the present invention, after sampling the output voltage and output current of the inverter power supply and calculating the output apparent power, an active load online detection algorithm is executed for secondary detection under the condition where the apparent power is less than a preset power threshold, so that the load connection state can be automatically identified, the accuracy of load connection state detection for the energy storage power supply can be improved through the secondary detection, and especially, the misjudgment of the load connection state is reduced when the connected load is a low-power load, thereby avoiding a load power failure caused by misjudgment and shutdown of the output of the inverter power supply.

In some embodiments, the present invention has the following beneficial effects:
according to the load connection state detection method for the energy storage power supply in the embodiment of the present invention, by actively injecting voltage excitation to an output port of the inverter power supply and then detecting the voltage response at the output port, the load connection state of the energy storage power supply can be accurately detected without increasing any hardware circuit and volume occupation.

According to the energy saving control method for energy storage power supply in the embodiment of the present invention, the active load online detection algorithm is circularly executed when the detection result is that no load is connected to the energy storage power supply, and the active load online detection algorithm controls the driving of the inverter bridge to perform waveform generation starting from the zero point of the sinusoidal reference wave, and immediately performs waveform blocking and disables all the PWM driving signals at the peak of the sinusoidal reference wave, so that the driving of the inverter bridge only performs waveform generation for 0.25 power frequency cycles in one RC discharge cycle, which can reduce the working time ratio of the inverter power supply. As compared to the continuous waveform generation and output of the inverter power supply under no-load conditions, the no-load loss of the main power circuit of the inverter power supply according to the present invention is greatly reduced.

In the energy saving control method for energy storage power supply according to the present invention, after the active load online detection algorithm is executed, the driving of the inverter bridge for waveform initiation is initiated when it is determined that a load is connected to the energy storage power supply, so that the inverter power supply restores the rated AC sinusoidal wave output. In this way, the inverter power supply can automatically start up when it is detected that a load is connected, thereby reducing the no-load loss of the energy storage power supply on the premise of realizing automatic startup of the energy storage power supply under loaded conditions.

Other beneficial effects in the embodiments of the present invention will be further described in the following description.

## Brief Description of the Drawings

FIG. 1 is a flowchart diagram of a load connection state detection method for an energy storage power supply according to an embodiment of the present invention.

FIG. 2 is a schematic diagram of the load connection state detection method for an energy storage power supply according to an embodiment of the present invention.

FIG. 3 is a schematic diagram of low-power load connection state detection for an energy storage power supply according to an embodiment of the present invention.

FIG. 4 is a flowchart diagram of a load connection state detection method for an energy storage power supply and an active load online detection algorithm according to an embodiment of the present invention.

FIG. 5 is a flowchart diagram of an energy saving control method for energy storage power supply according to an embodiment of the present invention.

## Detailed Description of the Embodiments

Hereinafter, the present invention will be further described with reference to the attached drawings and in combination with preferred embodiments. It shall be noted that the embodiments in this application and the features in the embodiments may be combined with each other without conflict.

Aiming at the demand of off-grid no-load loss reduction for the portable energy storage power supply, the embodiment of the present invention provides a method for reducing off-grid no-load loss of an inverter power supply, and the method provides a set of pure software control algorithm, which can automatically identify the load connection state without adding any hardware circuit, and realize automatic power-on/off control of the power supply, thereby reducing the no-load loss of the power supply.

An overview of the embodiments of the present invention is as follows.

An embodiment of the present invention provides a load connection state detection method for an energy storage power supply, the energy storage power supply includes an inverter power supply, the inverter power supply includes an inverter bridge, a controller and an AC output filter circuit, the inverter bridge is connected with the AC output filter circuit, the controller is connected with the inverter bridge and the AC output filter circuit, the AC output filter circuit includes a filter capacitor and a discharge resistor connected in parallel with the filter capacitor, and the AC output filter circuit is connected in parallel with a load when the load is connected.

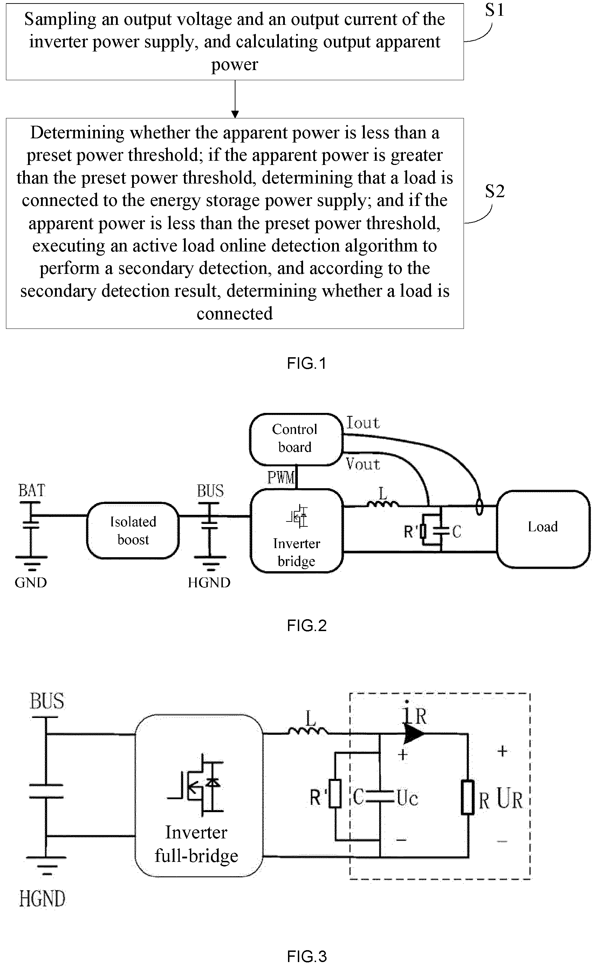

The load connection state detection method for the energy storage power supply, as shown in FIG. 1, includes the following steps:

S1: sampling an output voltage and an output current of the inverter power supply, and calculating output apparent power;

S2: determining whether the apparent power is less than a preset power threshold;

if the apparent power is greater than the preset power threshold, determining that a load is connected to the energy storage power supply; and

if the apparent power is less than the preset power threshold, executing an active load online detection algorithm to perform a secondary detection, and according to the secondary detection result, determining whether a load is connected.

The active load online detection algorithm includes: actively injecting a voltage excitation to an output port of the inverter power supply, then detecting the voltage response of the output port, and determining whether a load is connected according to the voltage response. This operation specifically includes the following steps:

A1: controlling, by the controller, the driving of the inverter bridge to initiate waveform generation starting from the zero point of the sinusoidal reference wave, and performing waveform blocking by disabling the driving signal at the peak of the sinusoidal reference wave, so that the voltage across the filter capacitor becomes the rated peak voltage of the inverter power supply;

A2: starting a timing process upon performing waveform blocking by disabling the driving signal, and sampling and monitoring the voltage across the filter capacitor in real time during the timing process;

A3: stopping the timing process when the voltage across the filter capacitor is detected to have dropped to a preset voltage value, and obtaining a timing value, the timing value being the discharge duration of the voltage across the filter capacitor from the rated peak voltage to the preset voltage value;

wherein the preset voltage value is 3% to 10% of the rated peak voltage of the inverter power supply, preferably 5% of the rated peak voltage of the inverter power supply;

A4: calculating the rated power of the connected load according to the timing value, and determining whether the rated power of the load is less than a preset load power threshold;

if the rated power of the load is greater than the preset load power threshold, determining that a load is connected to the energy storage power supply; and

if the rated power of the load is less than the preset load power threshold, determining that no load is connected to the energy storage power supply.

An embodiment of the present invention further provides an energy saving control method for energy storage power supply. The energy saving control method for energy storage power supply, which includes the following steps:

B1: executing the load connection state detection method for the energy storage power supply described above to detect the load connection state of the energy storage power supply;

B2: if the detection result is that a load is connected to the energy storage power supply, then controlling, by the controller, the driving of the inverter bridge to initiate waveform generation thereby causing a inverter power supply to resume output of a rated AC sinusoidal waveform;

B3: if the detection result is that no load is connected to the energy storage power supply, and after the filter capacitor is discharged to a preset voltage value, controlling, by the controller, the driving of the inverter bridge to initiate waveform generation so as to execute the active load online detection algorithm.

In some embodiments, in the step B1, the load connection state of the energy storage power supply is detected with a preset frequency.

An embodiment of the present invention further provides a computer-readable storage medium storing a computer program, and the computer program, when executed by a processor, implements the steps of the load connection state detection method for the energy storage power supply described above.

An embodiment of the present invention further provides a computer-readable storage medium storing a computer program, and the computer program, when executed by a processor, implements the steps of the energy saving control method for the energy storage power supply described above.

An embodiment of the present invention further provides an energy storage power supply which includes a computer-readable storage medium and a processor, the computer-readable storage medium stores a computer program, and the computer program, when executed by the processor, implements the steps of the energy saving control method for the energy storage power supply described above.

Embodiments:

The load connection state detection method for the energy storage power supply provided in this embodiment is an improvement on the existing no-load state detection method for the energy storage power supply. As shown in FIG. 2, this embodiment performs algorithm improvement based on the existing circuit structure of the energy storage power supply system, and the load connection state can be automatically identified without adding any hardware circuit.

As shown in FIG. 2, the energy storage power supply includes an inverter power supply, which is a DC-AC inverter circuit consisting of an inverter bridge, a controller and an AC output filter circuit. The AC output filter circuit is composed of an inductor L and a filter capacitor C. R' is the discharge resistor for the filter capacitor C when it is turned off (which means the complete shutdown of the IGBT driving of the inverter bridge), and it is connected in parallel with the filter capacitor C. When a load is connected, the AC output filter circuit is connected in parallel with the load.

The inverter bridge is connected with the AC output filter circuit, and the controller is connected with the inverter bridge and the AC output filter circuit. The controller is used for driving control (for waveform blocking or waveform generation) of the inverter bridge and current/voltage sampling of the AC output filter circuit. The controller includes a sampling circuit, which uses a differential voltage sampling circuit for voltage sampling and a Hall sensor for current sampling.

The method specifically includes that following steps:

S1: sampling an output voltage $V_{out}$ and an output current $I_{out}$ of the inverter power supply, and calculating output apparent power $P_{out}$, the expression of which is as follows:

$$P_{out} = \sqrt{\frac{{}_{0}^{n}V_{out}(k)^2}{n}} \times \sqrt{\frac{{}_{0}^{n}I_{out}(k)^2}{n}} \; ;$$

wherein n is the total number of sampling points in a sinusoidal period, and k is the $k^{th}$ sampling point.

S2: setting a preset power threshold for the apparent power ( which is for example 1% of the rated apparent power), and determining whether the output apparent power is less than the preset power threshold, so as to generate a detection result;

if the apparent power is greater than the preset power threshold, the detection result is determined to be that a load is connected to the energy storage power supply; and

if the output apparent power is less than the preset power threshold, the controller of the inverter power supply executes an active load online detection algorithm, and outputs the detection result according to the active load online detection algorithm.

It shall be noted that, the inverter power supply is determined to be in a no-load state only when both of the following conditions are simultaneously satisfied: the apparent power being less than the preset power threshold, and the output result of the active load online detection algorithm being that "the inverter power supply is in a no-load state"; otherwise, the inverter power supply will be determined as in a loaded state. This avoids the shutdown of the inverter power supply caused by being mistakenly determined as being in a no-load state when a low-power load is connected.

The working principle of the active load online detection algorithm in this embodiment is as follows.

As shown in FIG. 3, the section enclosed by the dashed lines forms an RC discharge circuit by utilizing the filter capacitor C of the inverter power supply's own output filter and the impedance R of the external load. Given that the capacitance of the filter capacitor C is a known parameter, the R value of the load can be accurately calculated simply by applying an initial voltage $U_0$ to the filter capacitor C and measuring the zero-input response curve of the RC discharge circuit, i.e., measuring the discharge duration t of the voltage of the capacitor C from the initial value $U_0$ to $0.05\, U_0$ (R' is the discharge resistor connected in parallel with the filter capacitor C, usually with a resistance value of about 200 k$\Omega$, which is used to dissipate the residual voltage of the filter capacitor after the inverter power supply is turned off; when the inverter power supply is turned on under the loaded condition, the resistance value is much larger than the load resistor R, so it is disregarded at this pint). The calculation process of the R value of the load is as follows.

As shown in FIG. 3, the capacitor voltage is $U_C$, the voltage across the load resistor R is $U_R$, the current flowing through the load resistor is $i_R$, and the following equation can be obtained according to Kirchhoff's Voltage Law (KVL):

$$U_R - U_C = 0 \; ;$$

by substituting $U_R = i_R * R$, $i_R = -C\dfrac{dU_C}{dt}$ into the above equation, we can get:

$$RC\frac{dU_C}{dt} + U_C = 0 \; ;$$

as can be known from the above equation, the equation is a first-order homogeneous differential equation, and the initial

condition at time $t_0$ is $U_C(0+)=U_C(0-)=U_0$, so the general solution of the equation is $U_C = Ae^{pt}$, wherein A is a constant that is determined by the initial condition of the first-order homogeneous differential equation; $p$ is the characteristic root of the first-order homogeneous differential equation; t is a time variable; $Ae^{pt}$ is the general solution form of the first-order homogeneous differential equation.

By substituting the general solution into the above equation, we can obtain:

$$(RCp + 1)Ae^{pt} = 0 \,;$$

the characteristic equation is:

$$RCp + 1 = 0 \,;$$

the characteristic root is:

$$p = -\frac{1}{RC} \,;$$

according to the initial condition $U_C(0+)=U_C(0-)=U_0$, substituting $U_C = Ae^{pt}$ gives:

$$U_C = Ae^{p\times 0} = Ae^0 = U_0;$$

$$A = U_0;$$

and thus, the solution of the differential equation is obtained as follows:

$$U_C = U_0 e^{-\frac{1}{RC}t} \,;$$

at time t=0, an initial voltage $U_C(0)=U_0$ is applied to the filter capacitor, so that the RC discharge circuit starts to discharge, and the real-time voltage $U_C(t)$ on the capacitor is detected. When $U_C(t)=0.05U_0$, the discharge duration t is recorded.

In this embodiment, the reason why it is selected to record the discharge duration when the capacitor discharges to $0.05U_0$ is as follows.

The first reason is to mitigate the current surge, the inverter bridge needs to perform waveform generation at the sinusoidal zero-crossing point the next time the active load online detection algorithm is executed, so the capacitor voltage needs to be discharged to the lowest voltage value as much as possible, usually below 10% of the rated AC peak value.

The second reason is as follows: according to the discharge curve of the capacitor, when the capacitor voltage is discharged below 3% of the initial voltage, the voltage will drop more and more slowly, and the sampling accuracy of the capacitor voltage is poor at low voltage. In order to improve the speed and accuracy of the load online detection algorithm, it is required that the active load online detection algorithm is executed again when the capacitor voltage is discharged at minimum not lower than 3% of the initial rated AC peak. Based on the above two reasons, it is appropriate to record the discharge duration when the capacitor voltage is discharged to 3% $U_0$ to 10% $U_0$, and meanwhile, in order to simplify the calculation, 5% $U_0$ is the most preferred compromise.

By substituting t as a known parameter and $R$ as an unknown parameter into $U_C = U_0 e^{-\frac{1}{RC}t}$ , we can get:

$$U_C(t) = 0.05U_0 = U_0 e^{-\frac{1}{RC}t} \,;$$

$$e^{-\frac{1}{RC}t} = 0.05 \,;$$

$$-\frac{1}{RC}t = \ln(0.05) \approx -3 \,;$$

which can be organized into:

$$R = \frac{t}{3C} \;;$$

Because the discharge duration t of RC discharge circuit is a measured value and the capacitance C is a known parameter, the resistance value R of the connected load can be accurately calculated by the above equation, thereby realizing the load online automatic detection function.

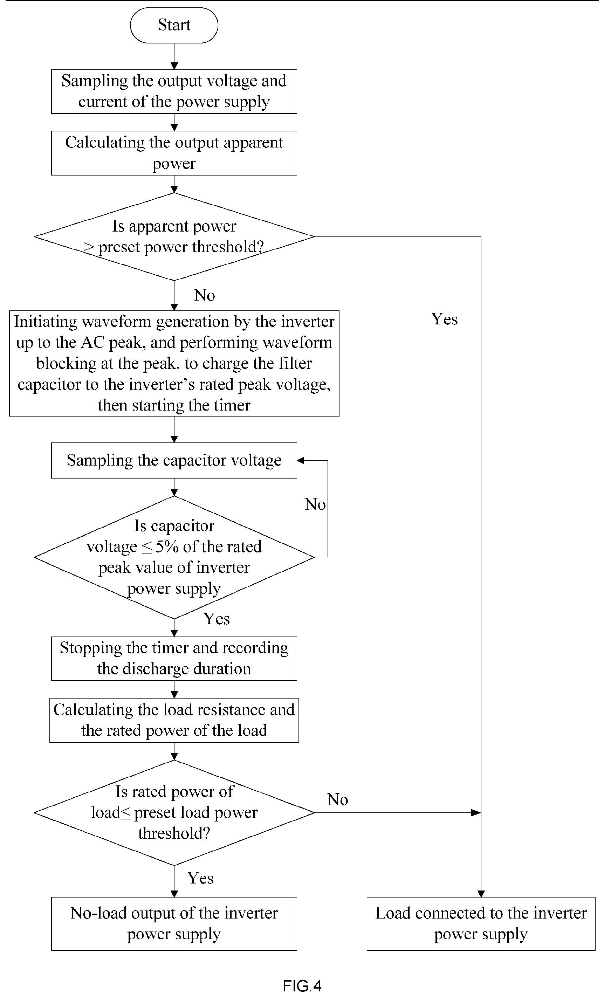

As shown in FIG. 4, the specific steps of the active load online detection algorithm in this embodiment on the inverter power supply are as follows:

A1: when it is detected that the output apparent power of the inverter power supply is less than the preset power threshold, the controller of the inverter power supply controls the driving of the IGBT (insulated gate bipolar transistor, which may also be a switch tube of other power devices) of the inverter bridge to initiate waveform generation starting from the zero-crossing point of the sinusoidal reference wave, and ,at the peak of the sinusoidal reference wave, immediately performs waveform blocking by disabling all the pulse width modulation (PWM) driving signals of the IGBT of the inverter bridge, so that the voltage output by the inverter power supply across both ends of the filter capacitor is the rated peak voltage of the inverter power supply; the rated peak voltage of the inverter power supply is $\sqrt{2}U_e$ ; meanwhile, initiates timing together with the waveform blocking of the inverter power supply.

A2: the controller starts a timing process upon performing waveform blocking by disabling the driving signal The waveform blocking meaning that the circuit between the filter capacitor C and the inverter bridge is disconnected, and a zero-input response is given to the RC discharge circuit formed by the filter capacitor C and the external load R. The voltage across the filter capacitor is sampled and monitored in real time during the timing process.

Specifically, when the pulse width modulation driving signal is disabled for waveform blocking, the on-chip Timer of the main control MCU of the inverter power supply is started for timing, and then the voltage $U_C$ across the filter capacitor C is sampled and monitored in real time.

A3: the controller stops the timing process when the voltage across the filter capacitor is detected to have dropped to a preset voltage value, and obtaining a timing value, the timing value being the discharge duration of the voltage across the filter capacitor from the rated peak voltage to the preset voltage value.

Specifically, when it is detected that the filter capacitor C has been discharged to the preset voltage value $U_C = 0.05 \times \sqrt{2}U_e$ , the Timer is stopped and the timing value of the Timer is recorded, thereby obtaining the discharge duration t of the voltage across the filter capacitor C from the rated peak voltage $\sqrt{2}U_e$ to the preset voltage value of $0.05 \times \sqrt{2}U_e$ .

A4: the controller calculates the rated power of the connected load according to the timing value, and determines whether the rated power of the load is less than a preset load power threshold, so as to generate a detection;

if the rated power of the load is greater than the preset load power threshold, the detection result is that a load is connected to the energy storage power supply; and

if the rated power of the load is less than the preset load power threshold, the detection result is that no load is connected to the energy storage power supply.

The specific operation is as follows:

In combination with the capacitance C of the output filter capacitor of the inverter power supply, the resistance of the connected load is calculated as follows:

$$R = \frac{t}{3C};$$

the rated output voltage of the inverter power supply is $U_e$, so the rated power of the connected load is calculated as follows:

$$P_R = \frac{U_e{}^2}{R}$$

a preset load power threshold is set (for example, the preset load power threshold is set to be 1 W), and when the calculated rated power of the load is less than the preset load power threshold, it is determined that the inverter power supply is in a no-load state, and otherwise it is determined that a load is connected to the inverter power supply.

As shown in FIG. 4, this embodiment further provides an energy saving control method for an energy storage power supply, which is used for automatic power-on/off control of the power supply (automatic control of the drive switch of the inverter bridge), and includes the following steps which is performed by the controller:

B1: executing the load connection state detection method for the energy storage power supply described above to detect the load connection state of the energy storage power supply;

B2: if the detection result is that a load is connected to the energy storage power supply, then controlling the driving of the inverter bridge to initiate waveform generation thereby causing a inverter power supply to resume output of a rated AC sinusoidal waveform;

B3: if the detection result is that no load is connected to the energy storage power supply, then after the filter capacitor is discharged to a preset voltage value, controlling the driving of the inverter bridge to initiate waveform generation to execute the active load online detection algorithm.

The specific operation is as follows.

When the detection result of the load connection state detection method for the energy storage power supply is that the inverter power supply is in the no-load state, that is, no load is connected to the energy storage power supply, the following operations are performed.

After it is monitored that the voltage of the output filter capacitor is discharged from $\sqrt{2}U_e$ to the preset voltage value of $0.05 \times \sqrt{2}U_e$, the controller of the inverter power supply will again control the driving of the IGBT of the inverter bridge to initiate waveform generation starting from the zero-crossing point of the sinusoidal reference wave, then perform waveform blocking at the peak of the sinusoidal reference wave, and then re-charge the output filter capacitor C to the rated peak voltage and execute the active load online detection algorithm again.

When no load is connected, the discharge resistor R' and the filter capacitor C form an RC discharge circuit, and the resistance value of R' is usually about 200 kΩ. If the filter capacitor C is 10 uF, then the discharge duration $T_{Rc}$ required for discharging the voltage of the filter capacitor from $\sqrt{2}U_e$ to $0.05 \times \sqrt{2}U_e$ is calculated as follows:

$$0.05 \times \sqrt{2}U_e = \sqrt{2}U_e \mathrm{e}^{-\frac{1}{RC}T_{RC}} \; ;$$

$$T_{RC} \approx 3RC = 3 \times 200 \times 10^3 \times 10 \times 10^{-6} = 6s$$

The inverter bridge will only perform waveform generation for 0.25 power frequency cycles (from the zero-crossing point of the AC reference wave to the peak) in one RC discharge cycle. If the rated output frequency is 50Hz, then the waveform generation time $T_{INV}$ of the inverter power supply in one RC discharge cycle is:

$$T_{INV} = 0.25 \times \frac{1}{50} = 5 \times 10^{-3}s$$

Therefore, the working time ratio of the inverter power supply under the no-load condition is:

$$\frac{T_{INV}}{T_{RC}} = \frac{5 \times 10^{-3}}{6} = \frac{1}{1200}$$

That is to say, as compared to the continuous waveform generation and output of the inverter power supply under the no-load condition, the no-load loss of the main power circuit of the inverter power supply adopting this technical solution is only 1/1200 of the original value, which is basically equivalent to the shutdown of the inverter power supply.

When the detection result of the load connection state detection method of the energy storage power supply is that the inverter power supply is in a loaded state, the following operations are performed.

When a load is connected to the output port of the inverter power supply, the R value (the resistance value of the load) of the RC discharge circuit will be much smaller than the resistance value of the discharge resistor R' (for example, 200 kΩ), and the voltage across the filter capacitor C will quickly discharge to close to 0 V. At this point, when the rated power of the load is calculated to be greater than the lower threshold, the controller of the inverter power supply will immediately initiate the driving of the inverter bridge for waveform generation, and the inverter power supply restores the rated AC sinusoidal wave output for load driving, and the time interval between the load connection and the normal output of the inverter power supply will not exceed one power frequency cycle.

Aft the normal output of the inverter power supply, the load connection state of the energy storage power supply is detected with a preset detection frequency, and when the apparent power of the load is detected again to be less than the preset power threshold, the active load online detection algorithm will be executed again, so that the load connection state can be detected in real time, and the no-load loss of the inverter power supply can be reduced to the maximum extent.

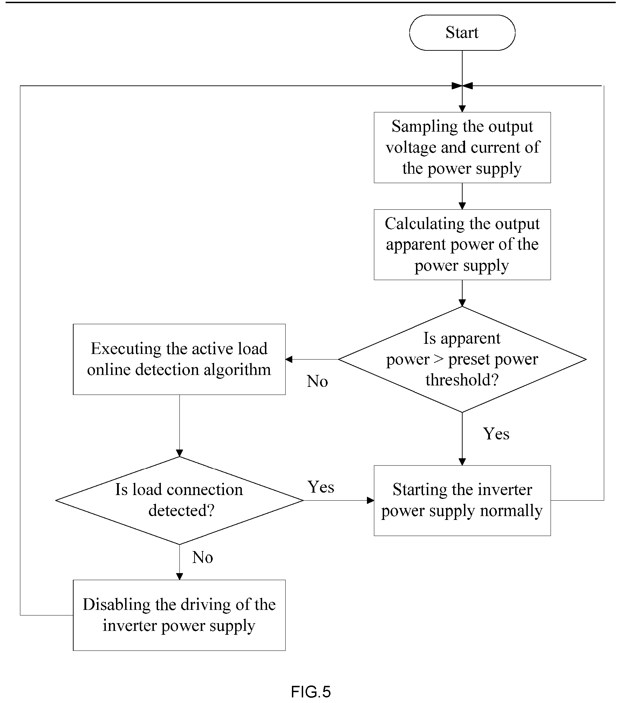

As shown in FIG. 5, after adopting the energy saving control method for the energy storage power supply in this embodiment, the no-load loss of the power supply can be greatly reduced without any hardware change, so that the no-load power-on loss of the inverter power supply is close to the complete power-off state.

At the same time, the active load online detection algorithm in this embodiment can automatically and quickly identify the connection and disconnection of the load, and can quickly and automatically perform the switching action of the inverter power supply according to the load connection situation. For users, there is no difference as compared to the continuous no-load power-on state of the power supply, and manual operation is not needed. Moreover, it solves the problem of shutdown of the power supply due to misjudgment when a low-power load is connected, and perfectly combines all the advantages of the existing technical solutions for reducing the off-grid no-load loss of the inverter power supply.

Experimental example

In this experimental example, the energy saving control method for energy storage power supply is adopted. In the application of a portable energy storage power supply with a battery capacity of 600 Wh, an output power of 600 W and an output voltage of 220V/50Hz, the battery output power measured under the following three working conditions is shown in Table 1: only the controller being powered on; Alternating current (AC) normal power-on no-load output; and adopting the energy saving control method for the energy storage power supply described above.

Table 1

| Working condition | Battery voltage (V) | Battery output current (A) | Battery output power (W) |
|---|---|---|---|
| Only the controller being powered on | 22.74 | 0.13 | 2.9562 |
| AC no-load normal power-on operation | 22.67 | 0.59 | 13.3753 |
| AC no-load loss reduction | 22.73 | 0.15 | 3.4095 |

In Table 1, "Only the controller being powered on" (corresponding to the controller in the circuit diagram being turned on separately) means that only the low-voltage controller and the human-machine interaction interface in the entire inverter power supply are powered, while the main power circuit is not powered. At this point, the inverter power supply can work normally only after the startup operation (initiation of the AC output) is performed manually. After adding the "AC no-load loss reduction" function, the inverter power supply can automatically identify the connection of the load and start up automatically without human intervention. Thus, it can realize the same on-load function as "AC no-load normal power-on operation", but only needs to consume the power as in the case of "Only the controller being powered on".

On the one hand, the battery output power is much less than that of the "AC no-load normal power-on operation", and on the other hand, switching action of the AC output can be quickly and automatically performed according to the load connection situation, which just consumes slightly more power than that of "only the controller being powered on".

The energy saving control method for the energy storage power supply in this experimental example is simple, but provides an obvious effect of reducing the no-load loss of the inverter power supply and provides strong universality, so that it can be applied to all single-phase inverter power supply equipment, three-phase inverter power supply equipment and three-frame inverter systems composed of three single-phase inverter power supplies.

What described above is a further detailed description of the present invention made in combination with specific preferred embodiments, but it should not be considered that the specific implementation of the present invention is limited to these descriptions. For those skilled in the art, several equivalent substitutions or obvious variations with the same performance or application can be made without departing from the concept of the present invention, which should all be regarded as within the scope claimed in the present invention.

**Claims**

1.  A load connection state detection method for an energy storage power supply, the energy storage power supply comprises an inverter power supply, being **characterized in that**, the method comprises the following steps:

S1: sampling an output voltage and an output current of the inverter power supply, and calculating output apparent power;

S2: determining whether the apparent power is less than a preset power threshold; if the apparent power is greater than the preset power threshold, determining that a load is connected to the energy storage power supply; and if the apparent power is less than the preset power threshold, executing an active load online detection algorithm to perform a secondary detection, and according to the secondary detection result, determining whether a load is connected.

2. The method according to Claim 1, being **characterized in that**, the active load online detection algorithm comprises: actively injecting a voltage excitation into an output port of the inverter power supply, detecting a voltage response at the output port after the voltage excitation, and determining whether a load is connected according to the voltage response.

3. The method according to Claim 2, being **characterized in that**, the inverter power supply comprises an inverter bridge, a controller and an AC output filter circuit, wherein the inverter bridge is connected with the AC output filter circuit, the controller is connected with the inverter bridge and the AC output filter circuit, the AC output filter circuit comprises a filter capacitor and a discharge resistor connected in parallel with the filter capacitor, the AC output filter circuit is connected in parallel with a load when the load is connected; and the step of actively injecting a voltage excitation into an output port of the inverter power supply, detecting a voltage response at the output port after the voltage excitation, and determining whether a load is connected according to the voltage response further comprises the following steps:

A1: controlling, by the controller, the a driving of the inverter bridge to initiate waveform generation starting from the zero point of the sinusoidal reference wave, and performing waveform blocking by disabling a driving signal at the peak of the sinusoidal reference wave, so that the voltage across the filter capacitor becomes the rated peak voltage of the inverter power supply;

A2: starting a timing process upon performing waveform blocking by disabling the driving signal, and sampling and monitoring the voltage across the filter capacitor in real time during the timing process;

A3: stopping the timing process when the voltage across the filter capacitor is detected to have dropped to a preset voltage value, and obtaining a timing value, the timing value being the discharge duration of the voltage across the filter capacitor from the rated peak voltage to the preset voltage value;

A4: calculating a rated power of the connected load according to the timing value, and determining whether the rated power of the load is less than a preset load power threshold; if the rated power of the load is greater than the preset load power threshold, determining that a load is connected to the energy storage power supply; and if the rated power of the load is less than the preset load power threshold, determining that no load is connected to the energy storage power supply;

4. The method according to Claim 3, being **characterized in that**, the preset voltage value is 3% to 10% of the rated peak voltage of the inverter power supply.

5. The method according to Claim 4, being **characterized in that**, the preset voltage value is 5% of the rated peak voltage of the inverter power supply.

6. An energy saving control method for an energy storage power supply, being **characterized in that**, comprising the following steps :

B1: executing the method according to any of Claims 1 to 5 to detect the load connection state of the energy storage power supply;

B2: if a detection result is that a load is connected to the energy storage power supply, controlling, by the controller, a driving of a inverter bridge to initiate waveform generation thereby causing a inverter power supply to resume output of a rated AC sinusoidal waveform;

B3: if the detection result is that no load is connected to the energy storage power supply, and after the filter capacitor is discharged to the preset voltage value, controlling, by the controller, the driving of the inverter bridge to initiate waveform generation so as to execute an active load online detection algorithm.

7. The method according to Claim 6, being **characterized in that**, in the step B1, the load connection state of the energy storage power supply is detected with a preset detection frequency.

8. A computer-readable storage medium storing a computer program, being **characterized in that**, the computer program, when executed by a processor, implements the steps of the method according to any of Claims 1 to 5.

9. A computer-readable storage medium storing a computer program, being **characterized in that**, the computer program, when executed by a processor, implements the steps of the method according to any of Claims 6 to 7.

10. An energy storage power supply, comprising a computer-readable storage medium and a processor, the computer-readable storage medium storing a computer program, being **characterized in that**, the computer program, when executed by the processor, implements the steps of the method according to any of Claims 6 to 7.

Sampling an output voltage and an output current of the inverter power supply, and calculating output apparent power

S1

Determining whether the apparent power is less than a preset power threshold; if the apparent power is greater than the preset power threshold, determining that a load is connected to the energy storage power supply; and if the apparent power is less than the preset power threshold, executing an active load online detection algorithm to perform a secondary detection, and according to the secondary detection result, determining whether a load is connected

S2

FIG.1

FIG.2

FIG.3

```
            ┌──────────┐
            │   Start  │
            └──────────┘
                 │
                 ▼
   ┌───────────────────────────────┐
   │ Sampling the output voltage and│
   │   current of the power supply  │
   └───────────────────────────────┘
                 │
                 ▼
   ┌───────────────────────────────┐
   │  Calculating the output apparent│
   │            power               │
   └───────────────────────────────┘
                 │
                 ▼
          ◇ Is apparent power ◇ ──── Yes ──────┐
          ◇ > preset power threshold? ◇        │
                 │                             │
                 No                            │
                 ▼                             │
   ┌───────────────────────────────┐          │
   │ Initiating waveform generation │          │
   │ by the inverter up to the AC   │          │
   │ peak, and performing waveform  │          │
   │ blocking at the peak, to charge│          │
   │ the filter capacitor to the    │          │
   │ inverter's rated peak voltage, │          │
   │ then starting the timer        │          │
   └───────────────────────────────┘          │
                 │                             │
                 ▼                             │
   ┌───────────────────────────────┐◄──┐      │
   │  Sampling the capacitor voltage│   │      │
   └───────────────────────────────┘   │      │
                 │                      No     │
                 ▼                      │      │
          ◇ Is capacitor ◇ ─────────────┘      │
          ◇ voltage ≤ 5% of the rated ◇        │
          ◇ peak value of inverter ◇           │
          ◇ power supply ◇                     │
                 │                             │
                 Yes                           │
                 ▼                             │
   ┌───────────────────────────────┐          │
   │ Stopping the timer and recording│          │
   │   the discharge duration       │          │
   └───────────────────────────────┘          │
                 │                             │
                 ▼                             │
   ┌───────────────────────────────┐          │
   │ Calculating the load resistance│          │
   │  and the rated power of the load│          │
   └───────────────────────────────┘          │
                 │                             │
                 ▼                             │
          ◇ Is rated power of ◇ ──── No ───────┤
          ◇ load ≤ preset load power ◇         │
          ◇ threshold? ◇                       │
                 │                             │
                 Yes                           │
                 ▼                             ▼
   ┌───────────────────────────────┐  ┌───────────────────────────────┐
   │ No-load output of the inverter │  │ Load connected to the inverter │
   │        power supply            │  │        power supply            │
   └───────────────────────────────┘  └───────────────────────────────┘
```

FIG.4

Start

Sampling the output
voltage and current of
the power supply

Calculating the output
apparent power of the
power supply

Is apparent
power > preset power
threshold?

Executing the active load
online detection algorithm

No

Is load connection
detected?

Yes

Starting the inverter
power supply normally

Yes

No

Disabling the driving of the
inverter power supply

FIG.5

## INTERNATIONAL SEARCH REPORT

| International application No. |
| --- |
| **PCT/CN2023/128048** |

**A. CLASSIFICATION OF SUBJECT MATTER**

G01R31/40(2020.01)i; H02M1/08(2006.01)i

According to International Patent Classification (IPC) or to both national classification and IPC

**B. FIELDS SEARCHED**

Minimum documentation searched (classification system followed by classification symbols)

IPC: G01R, H02M

Documentation searched other than minimum documentation to the extent that such documents are included in the fields searched

Electronic data base consulted during the international search (name of data base and, where practicable, search terms used)

CJFD, CNABS, CNTXT, VEN, ENTXTC: 视在功率, 阈值, 负载, 逆变, 有, 接入, 存在, 比较, inverter, apparent power, apparent output, compare, threshold, load

**C. DOCUMENTS CONSIDERED TO BE RELEVANT**

| Category* | Citation of document, with indication, where appropriate, of the relevant passages | Relevant to claim No. |
| --- | --- | --- |
| PX | CN 115963424 A (SHENZHEN POWEROAK NEWENER CO., LTD.) 14 April 2023 (2023-04-14) <br> claims 1-10 | 1-10 |
| A | CN 105656319 A (ZHEJIANG LEIYA ELECTRONICS CO., LTD.) 08 June 2016 (2016-06-08) <br> description, paragraphs 39-70, and figures 2-3 | 1-10 |
| A | CN 106841773 A (SHENZHEN CLOU ELECTRONICS CO., LTD.) 13 June 2017 (2017-06-13) <br> entire document | 1-10 |
| A | CN 113300359 A (SHENZHEN SAIDI FUDE TECHNOLOGY CO., LTD.) 24 August 2021 (2021-08-24) <br> entire document | 1-10 |
| A | CN 114123330 A (GINLONG TECHNOLOGIES CO., LTD.) 01 March 2022 (2022-03-01) <br> entire document | 1-10 |

☑ Further documents are listed in the continuation of Box C.  ☑ See patent family annex.

| | | | |
| --- | --- | --- | --- |
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **23 February 2024** | **26 February 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/128048**

### C. DOCUMENTS CONSIDERED TO BE RELEVANT

| Category* | Citation of document, with indication, where appropriate, of the relevant passages | Relevant to claim No. |
|---|---|---|
| A | CN 115776130 A (BEIJING SOARING ELECTRIC TECHNOLOGY CO., LTD.) 10 March 2023 (2023-03-10)<br>    entire document | 1-10 |
| A | EP 2717405 A1 (BORRI S.P.A.) 09 April 2014 (2014-04-09)<br>    entire document | 1-10 |
| A | JP 2020054223 A (TOSHIBA MITSUBISHI-ELECTRIC INDUSTRIAL SYSTEMS CORP.) 02 April 2020 (2020-04-02)<br>    entire document | 1-10 |
| A | US 2008111527 A1 (SARMAST SAM M) 15 May 2008 (2008-05-15)<br>    entire document | 1-10 |
| A | US 2012320641 A1 (SOLARBRIDGE TECHNOLOGIES, INC. et al.) 20 December 2012 (2012-12-20)<br>    entire document | 1-10 |
| A | US 2015097504 A1 (HAROLD WELLS ASSOCIATES, INC.) 09 April 2015 (2015-04-09)<br>    entire document | 1-10 |
| A | WO 2020030671 A1 (MASCHINENFABRIK REINHAUSEN GMBH et al.) 13 February 2020 (2020-02-13)<br>    entire document | 1-10 |

Form PCT/ISA/210 (second sheet) (July 2022)

**INTERNATIONAL SEARCH REPORT**
**Information on patent family members**

International application No.

**PCT/CN2023/128048**

| Patent document cited in search report | | | Publication date (day/month/year) | Patent family member(s) | | | Publication date (day/month/year) |
|---|---|---|---|---|---|---|---|
| CN | 115963424 | A | 14 April 2023 | None | | | |
| CN | 105656319 | A | 08 June 2016 | None | | | |
| CN | 106841773 | A | 13 June 2017 | None | | | |
| CN | 113300359 | A | 24 August 2021 | None | | | |
| CN | 114123330 | A | 01 March 2022 | None | | | |
| CN | 115776130 | A | 10 March 2023 | None | | | |
| EP | 2717405 | A1 | 09 April 2014 | EP | 2717405 | B1 | 19 August 2015 |
| | | | | ITAR | 20120030 | A1 | 05 April 2014 |
| JP | 2020054223 | A | 02 April 2020 | JP | 7105216 | B2 | 22 July 2022 |
| US | 2008111527 | A1 | 15 May 2008 | US | 7832820 | B2 | 16 November 2010 |
| US | 2012320641 | A1 | 20 December 2012 | US | 8767421 | B2 | 01 July 2014 |
| US | 2015097504 | A1 | 09 April 2015 | US | 9628016 | B2 | 18 April 2017 |
| WO | 2020030671 | A1 | 13 February 2020 | None | | | |

Form PCT/ISA/210 (patent family annex) (July 2022)